(19) Europäisches Patentamt / European Patent Office / Office européen des brevets

(11) **EP 2 755 243 A1**

(12) **EUROPEAN PATENT APPLICATION**
published in accordance with Art. 153(4) EPC

(43) Date of publication:
**16.07.2014 Bulletin 2014/29**

(51) Int Cl.:
***H01L 31/042*** *(2014.01)*

(21) Application number: **12830051.4**

(22) Date of filing: **03.09.2012**

(86) International application number:
**PCT/JP2012/072342**

(87) International publication number:
**WO 2013/035667 (14.03.2013 Gazette 2013/11)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.09.2011 JP 2011193340**

(71) Applicant: **Dexerials Corporation Tokyo 141-0032 (JP)**

(72) Inventors:
• **OKUMIYA, Hideaki**
  **Tokyo 141-0032 (JP)**
• **SUGA, Yasuhiro**
  **Tokyo 141-0032 (JP)**
• **HIGUCHI, Akifumi**
  **Tokyo 141-0032 (JP)**
• **SHIN, Yasumasa**
  **Tokyo**
  **1410032 (JP)**
• **FUJII, Takahiro**
  **Tokyo 141-0032 (JP)**

(74) Representative: **Müller - Hoffmann & Partner Patentanwälte St.-Martin-Strasse 58 81541 München (DE)**

(54) **SOLAR CELL MODULE MANUFACTURING METHOD, SOLAR CELL MODULE, AND TAB WIRE CONNECTION METHOD**

(57)    The object of the present invention is to ensure a sufficient reliability of the connection between a tab wire and a solar cell and also to maintain output power. The present invention provides such a configuration that is provided with a plurality of solar cells (2), each having a plurality of linear electrodes (12) serving as surface electrodes formed on one surface side by side, with a back surface electrode (13) formed on the other surface; and a tab wire 3 that is formed on the plural surface electrodes (12) of the one solar cell (2) so as to intersect therewith, and is also formed on the back surface electrode (13) of another solar cell (2) adjacent to the one solar cell (2), with an adhesive agent (17) interposed therebetween, and by carrying out heating and pressing processes onto the tab wire (3) with a buffer material (31) interposed therebetween, the adhesive agent (17) is cured and the tab wire (3) is pressed onto the surface electrodes (12) so as to be deformed into a wave shape along the longitudinal direction; thus, it is possible to release a stress caused by linear expansion not only as a component in parallel with the in-plane direction of the solar cell (2), but also as a component in a vertical direction, and consequently to solve the above-mentioned problem.

FIG.2

**Description**

Field of the Invention

This invention relates to a solar cell module in which connecting electrodes of a plurality of solar cells are electrically connected to one another by tab wires, and a connection method of the solar cell module and the tab wires.
The present application asserts priority rights based on JP Patent Application 2011-193340 filed in Japan on September 5, 2011. The total contents of disclosure of the Patent Application of the senior filing date are to be incorporated by reference into the present Application.

Background of the Invention

In general, a solar battery is used as a solar cell module in which by connecting a plurality of solar cells in series with one after another, an output of 100 W or more is achieved.
In a crystal silicon-based solar cell module, a plurality of adjacent solar cells are connected by tab wires that serve as interconnectors, and are made of a conductive material formed by a ribbon-shaped copper foil or the like coated with solder. Each tab wire has its one end solder-connected to surface electrodes of one solar cell, with the other end being solder-connected to a back surface electrode of another adjacent solar cell, so that the respective solar cells are connected in series with one after another (see Patent Document 1).
However, in the soldering process, since a connection process is carried out at a high temperature of about 260°C, warps of the solar cells might occur. Moreover, since fluxes are used in the soldering process, peeling of the sealing resin of the solar cell and degradation of the adhesion property thereof might occur due to residues of the fluxes.
Therefore, conventionally, a conductive adhesive film, which upon connecting the surface electrodes as well as the back surface electrode to the tab wires of solar cells, is capable of carrying out the connections by a thermal press-bonding process at a comparatively low temperature, has been used (Patent Document 2). With respect to this conductive adhesive film, a film-shaped material formed by dispersing spherical or scale-shaped conductive particles having an average particle size in the order of several $\mu$ms in a thermosetting binder resin composition is used.
After having been interposed between the surface electrodes as well as the back surface electrode and the tab wires, the conductive adhesive film is heated and pressed onto the tab wires so that the binder resin exerts flowability, and is allowed to flow out between the electrodes and the tab wires, with the conductive particles being sandwiched between the electrodes and the tab wires so as to provide conductivity between the two members, so that the binder resin is thermally cured in this state. Thus, strings in which a plurality of solar cells are conductively connected with one another by using the tab wires are prepared.
A plurality of solar cells, each having a structure in which tab wires, surface electrodes and a back surface electrode are connected to one another by using a conductive adhesive film, are sealed between a surface protective member having a translucent property made of glass, a translucent plastic material, or the like, and a back surface protective member made of a film such as PET (Poly Ethylene Terephthalate) or the like, by using a sealing material having a translucent property made of ethylene-vinyl acetate copolymer resin (EVA) or the like.

Prior-Art Documents

Patent Document

    PTL 1: Japanese Patent Application Laid-Open No. 2004-356349
    PTL 2: Japanese Patent Application Laid-Open No. 2008-135654

Summary of the Invention

In order to increase the output of the solar cell module, it is necessary to reduce a resistance value caused by the tab wire, and for this reason, the cross-sectional area of the tab wire needs to be increased. However, when the cross-sectional area of the tab wire is increased, the rigidity of the tab wire itself becomes greater. Moreover, with respect to the tab wire made of a copper foil or the like, the solar cell made of a silicon cell and the surface electrodes made of an Ag paste or the like, the linear expansion coefficient of the copper foil is greater than the linear expansion coefficient of the silicon cell and when the solar cell is heated, the copper foil is extended longer. For this reason, due to an inner stress exerted on the tab wire and the solar cell surface as well as on the connection portion with the electrodes formed on the surface and caused by the thermal expansion, the connection reliability between the tab wires might be lowered.

In particular, at the end portions of a solar cell 2, since stress strains generated relative to the tab wires are accumulated, cell cracks and warping might highly possibly occur, resulting in a subsequent problem of a reduction in output.

Moreover, in the crystal silicon-based solar cell, problems arise in that silicon serving as its raw material has to be obtained at low costs in a large quantity, and in recent years, very thin silicon wafers (for example, 200μm to 150μm) are cut out from a polycrystal silicon ingot and started to be used for mass production. In such a thin solar cell, since cracks and warping due to stress strain tend to easily occur, countermeasures for preventing a reduction in connection reliability of tab wires and a subsequent reduction in output due to these problems have been demanded.

Therefore, an object of the present invention is to provide a solar cell module that can ensure a sufficient connection reliability relative to a tab wire and maintain its output and a method of manufacturing such a solar cell module, as well as a connection method of the tab wire.

In order to solve the above-mentioned problems, a method of manufacturing a solar cell module in accordance with the present invention is provided with the steps of: disposing a plurality of solar cells, each having a plurality of linear electrodes serving as surface electrodes formed on one surface side by side, with a back surface electrode formed on the other surface; disposing a tab wire on the plural surface electrodes of the one solar cell so as to intersect therewith, as well as disposing a tab wire on the back surface electrode of another solar cell adjacent to the one solar cell, with an adhesive agent interposed therebetween; and by carrying out heating and pressing processes onto the tab wires with a buffer material interposed therebetween, curing the adhesive agent and connecting the tab wires and the linear electrodes to each other so that the tab wires are pressed onto the surface electrodes so as to be deformed into a wave shape along the longitudinal direction.

Moreover, a solar cell module in accordance with the present invention is provided with: a plurality of solar cells, each having a plurality of linear electrodes serving as surface electrodes formed on one surface side by side, with a back surface electrode formed on the other surface; and a tab wire that is formed on the plural surface electrodes of the one solar cell so as to intersect therewith, and also formed on the back surface electrode of another solar cell adjacent to the one solar cell so as to connect the one solar cell with the other solar cell, with an adhesive agent interposed therebetween, and in this configuration the tab wire is formed into a wave shape along a longitudinal direction in accordance with a height difference of the one surface on which the surface electrodes are formed side by side.

Furthermore, a method of connecting tab wires in accordance with the present invention is provided with the steps of: disposing a plurality of solar cells, each having a plurality of linear electrodes serving as surface electrodes formed on one surface side by side, with a back surface electrode formed on the other surface; disposing a tab wire on the plural surface electrodes of the one solar cell so as to intersect therewith, as well as disposing a tab wire on the back surface electrode of another solar cell adjacent to the one solar cell, with an adhesive agent interposed therebetween; and by carrying out heating and pressing processes onto the tab wires with a buffer material interposed therebetween, curing the adhesive agent and connecting the tab wires and the linear electrodes to each other so that the tab wires are pressed onto the surface electrodes so as to be deformed into a wave shape along the longitudinal direction.

Effects of Invention

In accordance with the present invention, by disposing a tab wire on a cell surface so as to intersect with a plurality of linear electrodes formed thereon with an adhesive agent interposed therebetween, as well as by carrying out heating and pressing processes from above the tab wire with a buffer material interposed therebetween, the adhesive agent is cured and the tab wire is pressed against the linear electrodes so as to be deformed into a wave shape along the longitudinal direction. Thus, even in the case when the solar cell module is exposed to high temperature environments, it is possible to release a stress that is caused by linear expansion and is conventionally directed in a parallel direction also as a component in a vertical direction so that a stress caused at a connection portion to the solar cell can be reduced, thereby making it possible to improve connection reliability. Therefore, since the present invention makes it possible to absorb the extension of the tab wire due to thermal expansion and also to improve the connection reliability, the initial output of the solar cell module can be maintained at a high rate.

Brief Description of Drawings

Figure 1 is an exploded perspective view showing a solar cell module.
Figure 2 is a cross-sectional view showing a string of solar cells.
Figure 3 is a plan view showing a back surface electrode and connection portions of each solar cell.
Figure 4 is a side view showing a process for connecting tab wires to the solar cell.
Figure 5 is a cross-sectional view showing a conductive adhesive film.
Figure 6 is a view showing the conductive adhesive film wound around into a reel shape.

Figure 7 is a cross-sectional view showing a connecting process of the tab wires.
Figure 8 is a plan view showing the solar cell on which auxiliary electrodes are formed.

Detailed Description of the Invention

Referring to Figures, the following description will discuss a method of manufacturing a solar cell module to which the present invention is applied and a connection method between the solar cell module and tab wires in detail. Additionally, the present invention is not intended to be limited only by the following embodiments, and it is needless to say that various modifications may be made therein within a scope not departing from the gist of the present invention. Moreover, Figures are schematic drawings, and the ratios or the like of the respective dimensions are sometimes different from those of actual values. Specific dimensions or the like should be determined by taking into consideration the following explanations. It is needless to say that among the Figures, portions having different relationships in dimensions and ratios are included in mutual Figures.

[Solar Cell Module]

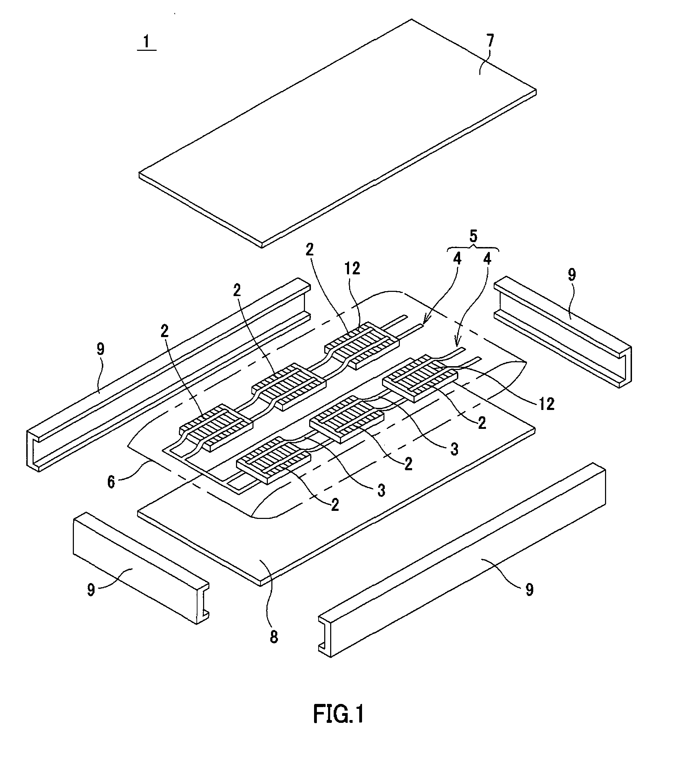

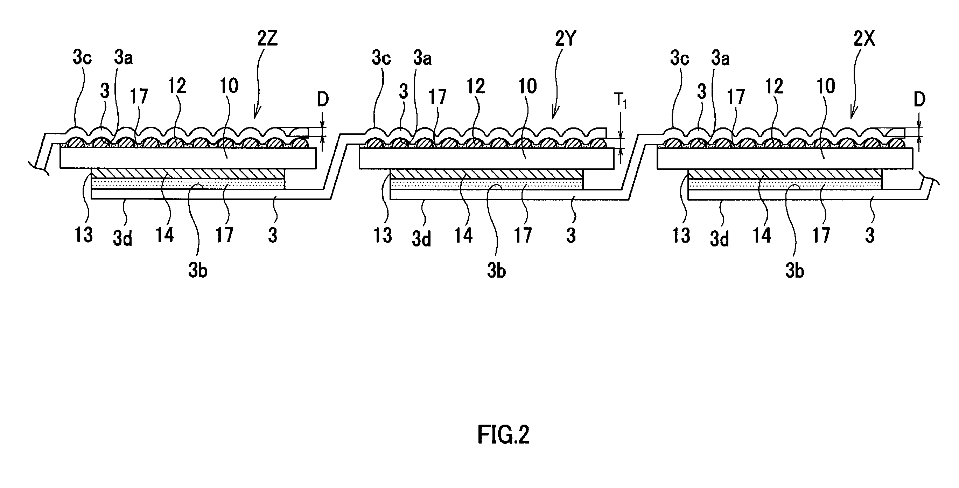

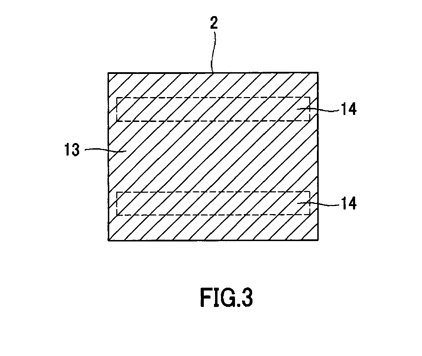

As shown in Figs. 1 to 3, a solar cell module 1 to which the present invention is applied has strings 4 each of which is formed by a plurality of solar cells 2 series-connected to one after another through tab wires 3 serving as interconnectors and a matrix 5 in which a plurality of these strings 4 are arranged. Moreover, the solar cell module 1 is formed by processes in which the matrix 5 is sandwiched by sheets 6 made of a sealing material and integrally laminated together with a surface cover 7 formed on a light-receiving surface side and a back sheet 8 formed on a back-surface side as one unit, and a metal frame 9 such as aluminum is lastly attached to the peripheral portion thereof.
As the sealing material, for example, a translucent sealing material, such as an ethylene-vinyl acetate copolymer resin (EVA) or the like, is used. Moreover, as the surface cover 7, for example, a translucent material, such as glass and a translucent plastic material, is used. As the back sheet 8, for example, a laminate member or the like in which glass or an aluminum foil is sandwiched by resin films is used.
Each of the solar cells 2 of the solar cell module is provided with photoelectric conversion elements 10. In the following description, explanations will be given by exemplifying a crystal silicon-based solar cell in which single crystal silicon-type photoelectric conversion elements or polycrystal silicon-type photoelectric conversion elements are used as the photoelectric conversion elements 10.
Moreover, each of the photoelectric conversion elements 10 has a configuration in which a plurality of linear finger electrodes 12 for use in collecting electricity generated inside of the light-receiving surface side are placed side by side. The finger electrodes 12 are formed by processes in which after, for example, an Ag paste have been applied onto a surface to be formed into the light-receiving surface of the solar cell 2 by a screen printing method or the like, the resulting surface is baked. The finger electrodes 12 have an arrangement in which over the entire surface of the light-receiving surface, lines having, for example, a width of about 50 to 200$\mu$m are formed with predetermined intervals of, for example, 2 mm, virtually in parallel with one after another.
The solar cells 2 have a so-called busbar-less structure which has no busbar electrodes on which the tab wires 3 are superposed. Moreover, in the solar cells 2, the tab wires 3 to be described later are directly connected to the finger electrodes 12 through a conductive adhesive film 17.
Moreover, each of the photoelectric conversion elements 10 is provided with a back-surface electrode 13 that is made of aluminum or silver, and formed on a back surface side opposite to the light-receiving surface. As shown in Figs. 2 and 3, as the back-surface electrode 13, for example, an electrode made of, for example, aluminum or silver, is formed on the back surface of the solar cell 2 by using a screen printing method, a sputtering method or the like. The back-surface electrode 13 is provided with tab wire connection portions 14 to which the tab wires 3 are connected through the conductive adhesive film 17 to be described later.
Moreover, in the solar cells 2, the finger electrodes 12 formed on the surface are electrically connected to the back-surface electrode 13 of an adjacent solar cell 2 by the tab wires 3 so that the series-connected strings 4 are configured. The tab wires 3, the finger electrodes 12 and the back-surface electrode 13 are connected to one another by the conductive adhesive film 17 to be described later.

[Tab Wire]

As shown in Fig. 2, each tab wire 3 is an elongated conductive base member for use in electrically connecting adjacent solar cells 2X, 2Y and 2Z to one after another. The tab wire 3 is prepared by slitting a copper foil or an aluminum foil rolled into, for example, a thickness of 50 to 300 $\mu$m or by rolling thin metal wires of copper, aluminum or the like into a flat plate shape so that a copper wire having a flat rectangular shape with a width of 1 to 3 mm that is virtually the same width as that of the conductive adhesive film 17. The tab wire 3 is then formed by carrying out gold plating, silver plating, tin plating, solder plating, or the like, onto the flat rectangular shaped copper wire, if necessary.

The tab wire 3 has its one surface 3a formed as a connection surface to the surface of the solar cell 2 on which the busbar electrodes 11 are formed, and the other surface 3b formed as a connection surface to a back surface of the solar cell 2 on which the back-surface electrode 13 is formed. Moreover, the tab wire 3 has its one end in the longitudinal direction formed as a surface connection portion 3c connected to the surface of the solar cell 2, and the other end in the longitudinal direction formed as a back-surface connection portion 3d connected to the back surface of the solar cell 2.

With this configuration, the tab wires 3 serve as interconnectors that electrically connect the adjacent solar cells 2X, 2Y and 2Z to one after another. Moreover, since the surface connection portions 3c of the tab wire 3 are disposed so as to intersect with the plural finger electrodes 12 formed on the light-receiving surface of the solar cell 2, the tab wires 3 compatibly serve as collector electrodes that collect power from the respective finger electrodes 12.

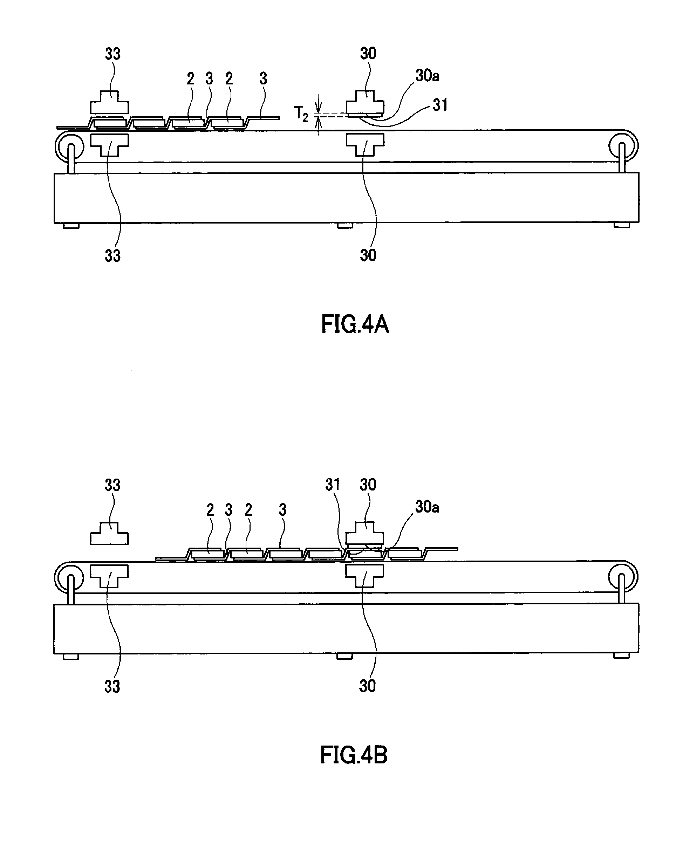

As shown in Figs. 4(A) and 4(B), after having been disposed on the light-receiving surface and the back surface of the solar cells 2, the tab wires 3 are thermally pressed thereon by a hot pressing head 30 with a buffer material 31 formed on its pressing surface 30a, so that the finger electrodes 12 and the back-surface electrode 13 are connected to each other through the conductive adhesive film 17.

At this time, as shown in Figs. 2 and 4, since each tab wire 3 is formed so as to intersect with the finger electrodes 12, it is formed into a wave shape along the longitudinal direction in accordance with a height difference between the finger electrodes 12 and the light-receiving surface of the solar cell 2, that is, in accordance with the height T1 of the finger electrode 12 and the thickness T2 of the buffer material 31. That is, the tab wire 3 is extended and located within the plane of the light-receiving surface of the solar cell 2, and raised upward from the light-receiving surface of the solar cell 2 by the finger electrodes 12 so as to be thus formed into a wave shape along the longitudinal direction. Therefore, even in the case when, upon thermally curing the conductive adhesive film 17 to be described later, the tab wire 3 is thermally pressed by the hot pressing head 30, or even in the case when, during the actual use of the solar cell module 1, the tab wire 3 is repeatedly exposed to high-temperature and low-temperature environments, the tab wire 3 makes it possible to release a stress caused by linear expansion not only as a component in parallel with the in-plane direction of the solar cell 2, but also as a component in a vertical direction. Additionally, the number of waves of the tab wire 3 is prepared in accordance with the number of the finger electrodes 12.

By forming the tab wire 3 into the wave shape along the longitudinal direction, the solar cell module 1 is allowed to absorb the extension of the tab wire 3 due to linear expansion, and makes it possible to reduce the inner stress caused by a difference in linear expansion coefficients between the solar cell 2 and the tab wire 3. That is, by releasing the stress caused by linear expansion of the tab wire 3 and conventionally directed only in a direction in parallel with the in-plane direction of the solar cell 2, as a vertical component, the solar cell module 1 makes it possible to reduce a stress applied onto the entire cell, in particular, a stress applied onto the cell ends, and consequently to prevent cracks and warping of the cell, thereby improving the connection reliability to the tab wires 3. Thus, the solar cell module 1 makes it possible to maintain the initial output at a high rate.

[Conductive Adhesive Film]

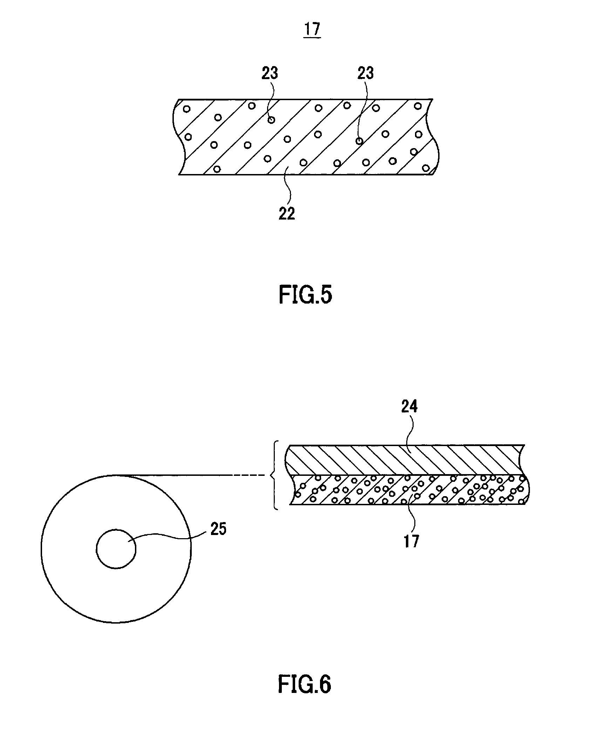

The following description will discuss the conductive adhesive film 17 serving as an adhesive agent for connecting the tab wires 3 to the surface and the back surface of the solar cells 2. As shown in Figs. 5 and 6, the conductive adhesive film 17 is prepared by filling conductive particles 23 at a high density into a thermosetting binder resin layer 22 composed of at least an epoxy resin and a curing agent.

Although not particularly limited, as the conductive particles 23 used for the conductive adhesive film 17, examples thereof include: metal particles such as nickel, gold, silver and copper, resin particles to which gold plating or the like is applied and resin particles that are subjected to gold plating thereon, with an insulating coating being applied onto the outermost layers thereof. Additionally, the conductive particles 23 having an average particle size in a range of 1 to 50$\mu$m are applicable, and those in a range of 10 to 30$\mu$m are more preferably used. Moreover, the shape of the conductive particles 23 is preferably formed into a spherical shape or a flat shape.

The composition of the thermosetting binder resin layer 22 of the conductive adhesive film 17 includes at least an epoxy resin and a curing agent, and preferably further contains a film-forming resin and a silane coupling agent.

As the epoxy resin, not particularly limited, all kinds of commercially available epoxy resins may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

The curing agent may have a potential characteristic. The potential curing agent is not allowed to react normally, but is activated with a certain trigger, and starts a reaction. As the trigger, heat, light, pressure or the like is used, and by making selection among these depending on the application, any of these may be used. Among these, in the present application, the potential curing agent of a hot setting-type is preferably used, and the curing agent is subjected to a main curing process by being heated and pressed by the hot pressing head 30, with the tab wires 3 being interposed therebetween.

The film-forming resin corresponds to a high-molecular-weight resin having an average molecular weight of 10000 or more, and from the viewpoint of a film forming characteristic, preferably, the average molecular weight thereof is set to about 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., the phenoxy resin is preferably used.

As the silane coupling agent, epoxy-based, amino-based, mercapto-sulfide-based, or ureide-based agents may be used. Among these, in the present embodiment, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, materials, such as silica, talc, titanium oxide, calcium carbonate, magnesium oxide or the like, may be used, and the kind of the inorganic filler is not particularly limited.

Fig. 6 is a schematic view that shows one example of a product mode of the conductive adhesive film 17. The conductive adhesive film 17 is provided with a peeling base member 24 with a binder resin layer 22 laminated thereon, and these are molded into a tape shape. This tape-shaped conductive adhesive film 17 is wound around and stacked on a reel 25, with the peeling base member 24 being located on the peripheral side. As the peeling base member 24, not particularly limited, PET (Poly Ethylene Terephthalate), OPP (Oriented Polypropylene), PMP (Poly-4-methylpentene-1), PTFE (Polytetrafluoroethylene) or the like may be used. Moreover, the conductive adhesive film 17 may have a structure in which a transparent cover film is formed on the binder resin layer 22.

At this time, as the cover film to be bonded to the binder resin layer 22, the above-mentioned tab wire 3 may be used. The conductive adhesive film 17 has a configuration in which the binder resin layer 22 is stacked on the one surface 3a forming an adhesive surface to the surface of the solar cell 2 of the tab wire 3, or on the other surface 3b forming an adhesive surface to the back surface of the solar cell 2. In this manner, by preliminarily stacking the tab wires 3 and the conductive adhesive film 17 integrally into one unit, the peeling base member 24 is separated therefrom at the time of an actual use, and by bonding the binder resin layer 22 of the conductive adhesive film 17 onto the finger electrodes 12 and the tab wire connection portions 14 of the back surface electrode 13, the tab wires 3 and the respective electrodes 12 and 13 are connected with one another.

The above explanation has been given on the conductive adhesive film having a film shape; however, a paste-state material may be used without causing any problems. When a conductive adhesive paste is used, the conductive adhesive paste is applied in a manner so as to intersect with the plural finger electrodes 12, or after having been applied onto the tab wire connection portions 14, the tab wires 3 are superposed thereon; or in addition to these processes, by preliminarily applying the conductive adhesive paste onto the one surface 3a and the other surface 3b of each tab wire 3 forming the adhesive surfaces to the solar cell 2, the tab wires 3 may be bonded onto the respective electrodes 12 and 13 of the solar cell 2, with the conductive adhesive paste interposed therebetween.

Moreover, in the present invention, an insulating adhesive film or an insulating adhesive paste, which is made of only the binder resin layer 22 without containing the conductive particles 23, may be used. In this case, by making the tab wires 3 and the finger electrodes 12 directly in contact with each other, conduction between these is secured. Furthermore, in the present invention, a laminated film in which the conductive adhesive film 17 and an insulating conductive film are stacked may be used. In the present application, these film-shaped conductive adhesive film 17 containing conductive particles, paste-state conductive adhesive paste, insulating adhesive film, and paste-state insulating adhesive paste, or a laminated member of these, are defined as "adhesive agent".

Additionally, not limited to a reel shape, the conductive adhesive film 17 may have a stripe shape formed in accordance with the shape of a bonding region to the plural finger electrodes 12 on the surface of the solar cell 2 or the shape of the tab wire connection portions 14 of the back surface electrode 13.

When, as shown in Fig. 6, the conductive adhesive film 17 is prepared as a reel product wound around the reel, by setting the viscosity of the conductive adhesive film 17 in a range from 10 to 10000 kPa•s, it becomes possible to prevent the conductive adhesive film 17 from being deformed, and consequently to maintain a predetermined dimension. In the case when two or more stripe-shaped conductive adhesive films 17 are stacked, it also becomes possible to prevent them from being deformed, and consequently to maintain a predetermined dimension.

[Production Process]

The above-mentioned conductive adhesive film 17 is prepared by dissolving the conductive particles 23, an epoxy resin, a curing agent, a film-forming resin and a silane coupling agent in a solvent. As the solvent, toluene, ethyl acetate or the like, or a mixed solvent of these, may be used. Solution for resin generation obtained by the dissolving process is applied onto a peeling sheet and the solvent is evaporated therefrom so that the conductive adhesive film 17 is obtained.

The conductive adhesive film 17 is cut into two pieces of predetermined lengths for the surface electrodes and two pieces of predetermined lengths for the back surface electrodes, and these pieces are temporarily bonded to predetermined positions on the surface and back surface of the solar cell 2. At this time, the conductive adhesive film 17 is mounted so as to intersect with the respective finger electrodes 12 formed on the surface of the solar cell 2, and is also mounted on the tab wire connection portion 14 of the back surface, and is then heated and pressed for a predetermined period of time (for example, 0.5 second) at such degrees of temperature (for example, 70°C) and pressure (for example, 0.5 MPa) as to cause flowability, but not to cause a main curing process by using a preliminarily bonding head 33 shown in Fig. 4(A).

Next, the tab wires 3, which are cut into predetermined lengths in the same manner, are disposed and superposed on the respective conductive adhesive films 17. At this time, the tab wires 3 are disposed such that the surface connection portions 3c on the one surface 3a intersect with the plural finger electrodes 12 with the conductive adhesive film 17 interposed therebetween, with the back surface connection portions 3d on the other surface 3b being disposed on the tab wire connection portions 14 of the back surface electrode 13. Next, the tab wires 3 are heated and pressed for a predetermined period of time (for example, about 15 seconds) at a predetermined temperature (for example, 180°C) and a predetermined pressure (for example, about 2 MPa) so as to thermally cure the binder resin of the conductive adhesive film 17 by the hot pressing head 30. Thus, the tab wires 3, the finger electrodes 12 and the back surface electrode 13 are connected with one another electrically as well as mechanically, with the conductive adhesive film 17 interposed therebetween.

In this manner, the solar cells 2 are transported right below the hot pressing head 30 one by one where the tab wires 3 are successively bonded to the finger electrodes 12 and the back surface electrode 13, and each solar cell 2 is connected to an adjacent solar cell 2 in series with, or in parallel with each other through the tab wires 3 so that the string 4 and the matrix 5 are configured.

Thereafter, the string 4 or the matrix 5, with the sheet 6 of a translucent sealing material such as EVA being stacked on the surface and back surface thereof, is laminated by a reduced pressure laminator together with the surface cover 7 and the back sheet 8. In this case also, the conductive adhesive film 17 is heated at a predetermined temperature (for example, 160°C) for a predetermined period of time (for example, about 20 minutes). Lastly, a metal frame 9 made of aluminum or the like is attached to the peripheral portion so that the solar cell module 1 is formed.

[Buffer Material]

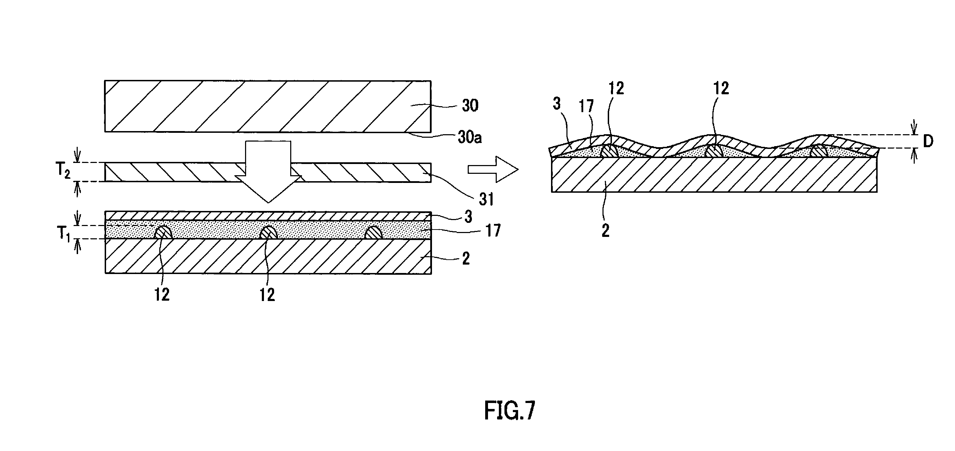

In this case, with respect to the hot pressing head 30 for thermally pressing the tab wires 3, as shown in Fig. 7, a buffer material 31 is formed on its pressing surface 30a for pressing the tab wires 3. The buffer material 31 is configured so as to exert such a function that when the thermally pressing process is carried out on the tab wires 3, it presses the tab wires 3 disposed on the plural finger electrodes 12 so as to intersect therewith, onto the finger electrodes 12 so as to be deformed into a wave shape along its longitudinal direction.

The buffer material 31, which is made of, for example, a silicone resin, is formed into a virtually rectangular plate shape capable of pressing the tab wires 3 along the longitudinal direction. Moreover, the buffer material 31 has a thickness T2 that is made thicker than a height T1 of the finger electrodes 12. Thus, when the tab wires 3 are pressed onto the finger electrodes 12, the buffer material 31 is deformed in accordance with the height T1 of the finger electrodes 12 so that as shown in Fig. 7, it presses each tab wire 3 onto the finger electrodes 12 so as to be bent along its height direction and formed into a wave shape with a predetermined height difference D along the longitudinal direction.

As shown in Figs. 2 and 7, each tab wire 3 is preferably designed so as to have a height difference D corresponding to a distance between the highest point and the lowest point of the wave shape of 5 $\mu$m or more, and more preferably used within a range of 5 to 45 $\mu$m. By setting the height difference D of the wave shape to 5 $\mu$m or more, when upon thermally curing the conductive adhesive film 17, the heating and pressing processes are carried out by the hot pressing head 30 or the laminate press-bonding process is carried out, or in the case when after the heating process, the resulting portion is cooled and solidified, or during an actual use of the solar cell module 1, the tab wires 3 are repeatedly subjected to high temperature and low temperature environments, the tab wires 3 are allowed to release a stress caused by linear expansion not only as a component in parallel with the in-plane direction of the solar cell 2, but also as a component in a vertical direction.

The height difference D of the tab wires 3 is determined by the height T1 of the finger electrodes 12 and the thickness T2 of the buffer material 31, and in order to set the height difference D of the tab wires 3 to 5 $\mu$m or more, it is preferable to satisfy the following inequality: (height of finger electrodes 12) / (thickness of buffer material 31) ≤ 0.3.

Moreover, the finger electrodes 12 are preferably designed to have the height T1 of 20 to 50 $\mu$m. Since the finger electrodes 12 are formed by applying a conductive paste, such as an Ag paste or the like and carrying out a baking process thereon, the height T1 is inevitably limited in order to form them in a stable manner.

Furthermore, the buffer material 31 is preferably designed to have the thickness T2 of 100 to 600 $\mu$m. In the case when the buffer material 31 is too thick, its thermal conductivity deteriorates, with the result that a long period of time is required to transmit heat by the hot pressing head 30 to the conductive adhesive film 17 under heating and pressing conditions for use in connecting the tab wires 3.

Therefore, the height T1 of the finger electrodes 12 is set to 20 to 50 $\mu$m and the thickness T2 of the buffer material 31 is set to 100 to 600 $\mu$m so that with this configuration, the inequality (height of finger electrodes 12) / (thickness of buffer material 31) $\leq$ 0.3 is preferably satisfied.

In the above-mentioned description, explanations have been given by exemplifying a solar cell module in which by drawing the tab wires 3 along the surface and the back surface of two mutually adjacent solar cells, conduction and connection are secured; however, the present invention may be applied to a so-called back contact-type solar cell module in which the tab wires 3 are connected to each other along the light-receiving surface and the back surface on the opposite side of two mutually adjacent solar cells.

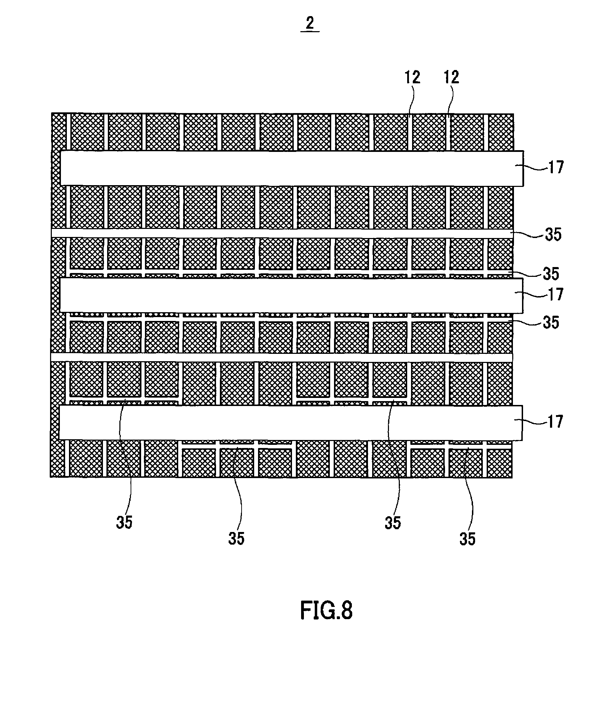

Moreover, the solar cell module 1 relating to the present invention is designed such that the tab wires 3 are pressed onto the finger electrodes 12 so as to be formed into a wave shape with a predetermined height difference, and the tab wires 3 are directly connected to the finger electrodes 12, without busbars being interposed therebetween; however, as shown in Fig. 8, except for the region in which the tab wires 3 are connected, the present invention may have an auxiliary electrode 35 for use in electrically connecting the plural finger electrodes 12 mutually to one another. The auxiliary electrode 35, which is formed so as to intersect with the plural finger electrodes 12 so that the finger electrodes 12 are mutually conducted to one another, is formed simultaneously with the finger electrodes 12, for example, by baking an Ag paste that has been screen-printed. Moreover, the auxiliary electrode 35 is formed so as to intersect with one portion or the entire portion of the finger electrodes 12 formed on the surface of the solar cell 2.

EXAMPLES

The following description will discuss examples of the present invention in comparison with a case in which the tab wires are connected without using a buffer material and a case in which the thickness of the buffer material is changed. In any of these examples and comparative examples, a solar cell composed of silicon crystal-type photoelectric conversion elements was used, and as the tab wires connected to the solar cell with a conductive adhesive film interposed therebetween, a tab wire having a width of 1.5 mm, formed by carrying out plating with a thickness of 5 $\mu$m on one surface of a copper foil having a thickness of 150 $\mu$m, was used. As the conductive adhesive film, a film of SP100 Series (made by Sony Chemical & Information Device Corporation) was used. Moreover, the tab wires are disposed on electrodes of the solar cell with the conductive adhesive film interposed therebetween, and by carrying out heating and pressing processes onto the tab wires by using a hot pressing head, the tab wires were conducted and connected to the respective electrodes on the surface and back surface of the solar cell. The connection conditions were 180°C, 15 seconds and 2 MPa.

In example 1, a so-called busbarless-type cell in which a plurality of linear finger electrodes were disposed side by side on the surface of a solar cell, without busbar electrodes formed thereon, was used. Moreover, a buffer material (rubber hardness: 70°) made of a silicone rubber was formed on the pressing surface of the hot pressing head.

Moreover, in example 1, the height of the finger electrodes was set to 30 $\mu$m and the thickness of the buffer material was set to 100 $\mu$m so that the ratio of (height of finger electrodes) / (thickness of buffer material) was adjusted to 0.3. On the tab wires formed by carrying out heating and pressing processes with this buffer material interposed therebetween, a wave shape having a height difference of 5.7 $\mu$m along the longitudinal direction was formed.

In example 2, the same configuration as that of example 1 was used except that the height of the finger electrodes was set to 30 $\mu$m and that the thickness of the buffer material was set to 200 $\mu$m so that the ratio of (height of finger electrodes) / (thickness of buffer material) was adjusted to 0.15. On the tab wires formed by carrying out heating and pressing processes with this buffer material interposed therebetween, a wave shape having a height difference of 20.1 $\mu$m along the longitudinal direction was formed.

In example 3, the same configuration as that of example 1 was used except that the height of the finger electrodes was set to 30 $\mu$m and that the thickness of the buffer material was set to 400 $\mu$m so that the ratio of (height of finger electrodes) / (thickness of buffer material) was adjusted to 0.08. On the tab wires formed by carrying out heating and pressing processes with this buffer material interposed therebetween, a wave shape having a height difference of 25.5 $\mu$m along the longitudinal direction was formed.

In example 4, the same configuration as that of example 1 was used except that the height of the finger electrodes was set to 30 $\mu$m and that the thickness of the buffer material was set to 600 $\mu$m so that the ratio of (height of finger electrodes) / (thickness of buffer material) was adjusted to 0.05. On the tab wires formed by carrying out heating and pressing processes with this buffer material interposed therebetween, a wave shape having a height difference of 26.1 $\mu$m along the longitudinal direction was formed.

In example 5, the same configuration as that of example 1 was used except that the height of the finger electrodes was set to 20 μm and that the thickness of the buffer material was set to 200 μm so that the ratio of (height of finger electrodes) / (thickness of buffer material) was adjusted to 0.1. On the tab wires formed by carrying out heating and pressing processes with this buffer material interposed therebetween, a wave shape having a height difference of 18.2 μm along the longitudinal direction was formed.

In example 6, the same configuration as that of example 1 was used except that the height of the finger electrodes was set to 50 μm and that the thickness of the buffer material was set to 200 μm so that the ratio of (height of finger electrodes) / (thickness of buffer material) was adjusted to 0.25. On the tab wires formed by carrying out heating and pressing processes with this buffer material interposed therebetween, a wave shape having a height difference of 40.1 μm along the longitudinal direction was formed.

In comparative example 1, the same busbarless-type cell as that of example 1 was used, and the tab wires were connected without using a buffer material. The height of the finger electrodes in comparative example 1 was set to 30 μm. In comparative example 1, on the tab wires on which heating and pressing processes were carried out without the buffer material interposed therebetween, no wave shape was formed.

In comparative example 2, the same configuration as that of example 1 was used except that the height of the finger electrodes was set to 30 μm and that the thickness of the buffer material was set to 10 μm so that the ratio of (height of finger electrodes) / (thickness of buffer material) was adjusted to 3. On the tab wires formed by carrying out heating and pressing processes with this buffer material interposed therebetween, a wave shape having a height difference of 2.2 μm along the longitudinal direction was formed.

In comparative example 3, the same configuration as that of example 1 was used except that the height of the finger electrodes was set to 30 μm and that the thickness of the buffer material was set to 50 μm so that the ratio of (height of finger electrodes)/(thickness of buffer material) was adjusted to 0.6. On the tab wires formed by carrying out heating and pressing processes with this buffer material interposed therebetween, a wave shape having a height difference of 3.2 μm along the longitudinal direction was formed.

In comparative example 4, a plurality of linear finger electrodes were placed side by side on the surface of a solar cell so as to intersect with a plurality of finger electrodes so that busbar electrodes for collecting power were formed, and the tab wires were connected onto the busbar electrodes. Moreover, a buffer material made of a silicone rubber was placed on the pressing surface of the hot pressing head.

In comparative example 4, the height of the finger electrodes was set to 30 μm and the thickness of the buffer material was set to 400 μm so that the ratio of (height of finger electrodes) / (thickness of buffer material) was adjusted to 0.08. On the tab wires formed by carrying out heating and pressing processes with this buffer material interposed therebetween, no wave shape was formed.

On each of the solar cells relating to the respective examples and comparative examples, after the tab wires had been connected thereto, a scanning process was carried out from the upper side of the tab wires by using a tracer type surface roughness meter (trade name SE-3H; made by Kosaka Laboratory Ltd.) so that the height difference of the wave shape was measured. Moreover, after the tab wires had been connected to each of the solar cells relating to the respective examples and comparative examples, sheets of EVA were stacked on the surface and back surface of the cell, and these were laminated together with a cover glass formed on the light-receiving surface side and a back sheet formed on the back surface side by using a laminator so as to be formed into a module.

Next, output measuring processes were carried out on each of the solar cell modules of the respective examples and comparative examples at the initial state after production of the solar cell module and after a thermal cycle test (-40°C: 30 minutes ↔ 100°C: 30 minutes, 600 cycles) thereof so that an output maintaining rate (maximum output after the thermal cycle test / maximum output immediately after formation of the module) was calculated. The measurements of respective photoelectric conversion efficiencies were carried out under conditions of illuminance of 1000 W/m$^2$, temperature of 25°C and spectrum of AM 1.5G by using a solar simulator (PVS1116i, made by Nisshinbo Mechatronics Inc.).

As a result of the measurements, evaluations were made based upon the following criteria: having 97% or more of the output maintaining rate was rated as ○; having 95% or more to 97% or less thereof was rated as Δ, and having 95% or less thereof was rated as X. Table 1 shows the results of the measurements.

[Table 1]

| | Example 1 | Example 2 | Example 3 | Example 4 | Example 5 | Example 6 |
|---|---|---|---|---|---|---|
| Presence / Absence of Busbar Electrode | Absence | Absence | Absence | Absence | Absence | Absence |
| Height of Finger Electrodes (μm) | 30 | 30 | 30 | 30 | 20 | 50 |
| Thickness of Buffer material (μm) | 100 | 200 | 400 | 600 | 200 | 200 |
| Height of Finger Electrodes / Thickness of Buffer material | 0.3 | 0.15 | 0.08 | 0.05 | 0.1 | 0.25 |
| Height Difference of Wave shape (μm) | 5.7 | 20.1 | 25.5 | 26.1 | 18.2 | 40.1 |
| Output Determination | ○ | ○ | ○ | ○ | ○ | ○ |
| Output Maintaining Rate — Initial | 1 | 1 | 1 | 1 | 1 | 1 |
| Output Maintaining Rate — After 600 Cycles | 0.972 | 0.979 | 0.979 | 0.981 | 0.978 | 0.980 |

| | Comparative Example 1 | Comparative Example 2 | Comparative Example 3 | Comparative Example 4 |
|---|---|---|---|---|
| Presence / Absence of Busbar Electrode | Absence | Absence | Absence | Presence |
| Height of Finger Electrodes (μm) | 30 | 30 | 30 | 30 |
| Thickness of Buffer material (μm) | - | 10 | 50 | 400 |
| Height of Finger Electrodes / Thickness of Buffer material | - | 3 | 0.6 | 0.08 |
| Height Difference of Wave shape (μm) | 0 | 2.2 | 3.2 | 0 |
| Output Determination | × | △ | △ | △ |
| Output Maintaining Rate — Initial | 1 | 1 | 1 | 1 |
| Output Maintaining Rate — After 600 Cycles | 0.945 | 0.951 | 0.966 | 0.956 |

As shown in Table 1, in accordance with examples 1 to 6, by heating and pressing tab wires with the buffer material thicker than the height of the tab wires interposed therebetween, the height difference of the wave shape of the tab wires is set to 5 μm or more. With this configuration, examples 1 to 6 make it possible to release a stress caused by linear expansion not only as a component in parallel with the in-plane direction of the solar cell, but also as a component in a vertical direction, even in the case of the heating and pressing processes by the hot pressing head and after the thermal cycle test. Therefore, in accordance with examples 1 to 6, the connection reliability between the tab wires and the finger electrodes 12 is improved and the output maintaining rate relative to the initial output immediately after production of the solar cell module is improved to be as high as 97% or more.

When examples 1 to 6 are compared with one another, it is found that as the height difference of the wave shapes of the tab wires becomes greater, the output maintaining rate after the thermal cycle test of the solar cell module tends to become higher. In the present examples, it is confirmed that by forming tab wires having a height difference of the wave shapes of about 40 $\mu$m at the maximum level, the output maintaining rate of 98% is achieved. Moreover, it is found that the height of the finger electrodes is set to 20 to 50 $\mu$m and, in particular, preferably set to 30 $\mu$m. The thickness of the buffer material is preferably set to 100 to 600 $\mu$m, and in particular, those having a thickness in a range from 200 to 400 $\mu$m are preferably used so as to form a predetermined height difference of the wave shape of the tab wires and also to transmit the heat of the hot pressing head in a short period of time.

On the other hand, in comparative example 1, since the hot pressing head is used for directly heating and pressing the tab wires without using a buffer material, it is not possible to form a wave shape on the tab wires. Consequently, in comparative example 1, the stress caused by the thermal expansion of the tab wires only has a parallel component, causing an excessive stress to be exerted on the solar cell surface and the finger electrodes formed on the corresponding surface. For this reason, the output maintaining rate relative to the initial output immediately after production of the solar cell module becomes less than 95%.

Moreover, in comparative example 2, since the thickness of the buffer material is thinner than the height of the finger electrodes, the buffer material fails to be deformed in accordance with the height of the finger electrodes, with the result that the wave shape of the tab wires becomes 2.2 $\mu$m, failing to satisfy 5 $\mu$m. For this reason, comparative example 2 fails to sufficiently release the stress caused by the thermal expansion of the tab wires as a vertical component in the case of the heating and pressing processes of the hot pressing head and after the thermal cycle test, resulting in a greater stress exerted on the surface of the solar cell surface and the finger electrodes. For this reason, the output maintaining rate relative to the initial output immediately after production of the solar cell module is lowered to about 95%.

Moreover, in comparative example 3, since, although a buffer material thicker than the height of the finger electrodes is used, it fails to satisfy the inequality of (height of the finger electrodes 12) / (thickness of the buffer material 31) $\leq$ 0.3, with the result that the height difference of the wave shape of the tab wires becomes 3.2 $\mu$m, failing to satisfy 5 $\mu$m. For this reason, comparative example 3 also fails to sufficiently release the stress caused by the thermal expansion of the tab wires as a vertical component in the case of the heating and pressing processes of the hot pressing head and after the thermal cycle test, resulting in a greater stress exerted on the surface of the solar cell surface and the finger electrodes. Consequently, the output maintaining rate relative to the initial output immediately after production of the solar cell module is lowered to less than 97%.

Moreover, in comparative example 4, since finger electrodes and busbar electrodes are formed and since the tab wires 3 are connected onto the busbar electrodes, it is not possible to form a wave shape on the tab wires although a buffer material is interposed on the pressing surface of the hot pressing head. Consequently, in comparative example 4, the stress caused by linear expansion of the tab wires is exerted only as a component in parallel therewith, with the result that an excessive stress is exerted onto the solar cell surface and the finger electrodes formed on the corresponding surface. For this reason, the output maintaining rate relative to the initial output immediately after production of the solar cell module is lowered to about 95%.

Reference Signs List

1...solar cell module, 2...solar cell, 3...tab wire, 4...string, 5...matrix, 6...sheet, 7...surface cover, 8...back sheet, 9...metal frame, 10...photoelectric conversion element, 12...finger electrode, 13...back surface electrode, 14...tab wire connection portion, 17...conductive adhesive film, 22...binder resin layer, 23...conductive particles, 24...peeling base member, 25...reel, 30...hot pressing head, 31...buffer material

**Claims**

1. A method of manufacturing a solar cell module comprising the steps of:

disposing a plurality of solar cells, each having a plurality of linear electrodes serving as surface electrodes formed on one surface side by side, with a back surface electrode formed on the other surface;
disposing a tab wire on the plural surface electrodes of the one solar cell so as to intersect therewith, as well as disposing a tab wire on the back surface electrode of another solar cell adjacent to the one solar cell, with an adhesive agent interposed therebetween; and

by carrying out heating and pressing processes onto the tab wires with a buffer material interposed therebetween, curing the adhesive agent and connecting the tab wires and the linear electrodes to each other so that the tab wires are pressed onto the surface electrodes so as to be deformed into a wave shape along the longitudinal direction.

2. The method of manufacturing a solar cell module according to claim 1, wherein the buffer material has a thickness that is thicker than a height of the surface electrodes.

3. The method of manufacturing a solar cell module according to claim 2, wherein the height of the surface electrodes is set to 20 to 50 μm.

4. The method of manufacturing a solar cell module according to claim 3, wherein the thickness of the buffer material is set to 100 to 600 μm.

5. The method of manufacturing a solar cell module according to any one of claims 2 to 4, wherein the height of the surface electrodes and the thickness of the buffer material are allowed to satisfy the following inequality:

$$\text{(height of finger electrode)} / \text{(thickness of buffer material)} \le 0.3.$$

6. The method of manufacturing a solar cell module according to any one of claims 1 to 5, wherein the tab wires have a height difference of the wave shape of 5 μm or more.

7. The method of manufacturing a solar cell module according to any one of claims 1 to 6, wherein the adhesive agent is preliminarily stacked on the surface of the tab wires.

8. A solar cell module comprising:

a plurality of solar cells, each having a plurality of linear electrodes serving as surface electrodes formed on one surface side by side, with a back surface electrode formed on the other surface; and
a tab wire that is formed on the plural surface electrodes of the one solar cell so as to intersect therewith , and also formed on the back surface electrode of another solar cell adjacent to the one solar cell so as to connect the one solar cell with the other solar cell, with an adhesive agent interposed therebetween,
wherein the tab wire is formed into a wave shape along a longitudinal direction in accordance with a height difference of the one surface on which the surface electrodes are formed side by side.

9. The solar cell module according to claim 8, wherein the height of the surface electrodes is set to 20 to 50 μm.

10. The solar cell module according to claim 8 or 9, wherein the tab wires have a height difference of the wave shape of 5 μm or more.

11. A method of connecting tab wires comprising the steps of:

disposing a plurality of solar cells, each having a plurality of linear electrodes serving as surface electrodes formed on one surface side by side, with a back surface electrode formed on the other surface;
disposing a tab wire on the plural surface electrodes of the one solar cell so as to intersect therewith, as well as disposing a tab wire on the back surface electrode of another solar cell adjacent to the one solar cell, with an adhesive agent interposed therebetween; and
by carrying out heating and pressing processes onto the tab wires with a buffer material interposed therebetween, curing the adhesive agent and connecting the tab wires and the linear electrodes to each other so that the tab wires are pressed onto the surface electrodes so as to be deformed into a wave shape along the longitudinal direction.

FIG.1

FIG.2

EP 2 755 243 A1

FIG.3

FIG.4A

FIG.4B

<u>17</u>

23    23

22

# FIG.5

24

25

17

# FIG.6

FIG.7

EP 2 755 243 A1

FIG.8

<table>
<tr><td colspan="2" align="center">**INTERNATIONAL SEARCH REPORT**</td><td colspan="2">International application No.<br>PCT/JP2012/072342</td></tr>
</table>

**A. CLASSIFICATION OF SUBJECT MATTER**
*H01L31/042*(2006.01)i

According to International Patent Classification (IPC) or to both national classification and IPC

**B. FIELDS SEARCHED**

Minimum documentation searched (classification system followed by classification symbols)
H01L31/042

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2012 |
| Kokai Jitsuyo Shinan Koho | 1971–2012 | Toroku Jitsuyo Shinan Koho | 1994–2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2006-80217 A (Sharp Corp.),<br>23 March 2006 (23.03.2006),<br>entire text; all drawings<br>& WO 2005/098969 A1 | 1-11 |
| A | JP 2005-302902 A (Sharp Corp.),<br>27 October 2005 (27.10.2005),<br>entire text; all drawings<br>& WO 2005/098969 A1 | 1-11 |
| A | JP 2002-280561 A (Mitsubishi Electric Corp.),<br>27 September 2002 (27.09.2002),<br>entire text; all drawings<br>(Family: none) | 1-11 |

☒ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 05 October, 2012 (05.10.12) | 16 October, 2012 (16.10.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2012/072342 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 11-312820 A  (Sanyo Electric Co., Ltd.),<br>09 November 1999 (09.11.1999),<br>entire text; all drawings<br>(Family: none) | 1-11 |
| A | JP 2006-278710 A  (Kyocera Corp.),<br>12 October 2006 (12.10.2006),<br>entire text; all drawings<br>(Family: none) | 1-11 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011193340 A
- JP 2004356349 A
- JP 2008135654 A